Europäisches Patentamt

European Patent Office

Office européen des brevets

(19)

(11) Veröffentlichungsnummer : **0 175 995 B1**

(12) # EUROPÄISCHE PATENTSCHRIFT

(45) Veröffentlichungstag der Patentschrift :
03.01.90

(21) Anmeldenummer : 85111384.5

(22) Anmeldetag : 09.09.85

(51) Int. Cl.⁵ : **G 01 R   1/073**

(54) **Einrichtung für die Funktionsprüfung integrierter Schaltkreise.**

(30) Priorität : 21.09.84 DE 3434749

(43) Veröffentlichungstag der Anmeldung :
02.04.86 Patentblatt 86/14

(45) Bekanntmachung des Hinweises auf die Patenterteilung : 03.01.90 Patentblatt 90/01

(84) Benannte Vertragsstaaten :
AT BE CH DE FR GB IT LI LU NL SE

(56) Entgegenhaltungen :
DE—A— 3 143 768
US—A— 3 909 934
US—A— 4 411 719

(73) Patentinhaber : **Siemens Aktiengesellschaft
Wittelsbacherplatz 2
D-8000 München 2 (DE)**

(72) Erfinder : **Becker, Reinhold
Castellstrasse 81
D-8500 Nürnberg (DE)**

EP 0 175 995 B1

**Beschreibung**

Die Erfindung betrifft eine Einrichtung für die Funktionsprüfung von elektronischen Prüflingen mit einer Vielzahl von Prüflings Anschlüssen, insbesondere von elektronischen Schaltkreisen, mit den Merkmalen des Oberbegriffes von Anspruch 1.

Solche Einrichtung sind beispielsweise bekannt aus dem Firmenprospekt Fairchild Product Description 5/81 Nr. 57148901 (LSI Test System).

Bei integrierten Schaltkreisen besteht sowohl auf der Hersteller- als auch auf der Anwenderebene das Bedürfnis, durch systematische Funktionsprüfungen defekte Produkte zu erkennen : Der Hersteller muß zum einen aus Gründen der Konkurrenzfähigkeit einen hohen Qualitätsstandard seiner Lieferungen sicherstellen und benötigt zum anderen für seinen betriebsinternen Produktionsprozeß Rückmeldedaten ; der Anwender will nur einwandfreie Ware bezahlen, die Zuverlässigkeit verschiedener Lieferanten beurteilen können und Störungen in der eigenen Produktion als Folge fehlerhafter Zulieferteile vermeiden.

Die erreichte und weiterhin zunehmende Komplexität integrierter Schaltkreise — immer mehr Funktionen werden auf einem Halbleiterchip zusammengefaßt — erfordert aus technischen und wirtschaftlichen Gründen eine Automatisierung des Prüfablaufs. In erster Linie ist hierzu der Einsatz von Elektronenrechnern zu zählen, unter deren Kontrolle Prüfprogramme, z. B. bei digital arbeitenden Prüflingen definierte Folgen von Bitmustern, am Prüfling ablaufen. In mechanischer Hinsicht ist die manuelle Zuführung des Prüflings zum Prüfplatz durch Beschickungseinrichtungen, auch Handhabungsautomaten, ersetzbar.

Mit der Komplexität der integrierten Schaltkreise hängt ein weiteres, praktisches Problem direkt zusammen : Die große Zahl externer Anschlüsse (Pins), die für den Zugriff zu den hochintegrierten Funktionen erforderlich sind, wirft Anordnungs- und Kontaktierungsschwierigkeiten auf.

Speziell bei einer Prüfeinrichtung für integrierte Schaltkreise stellt sich hierbei das Problem, daß sie einerseits hinsichtlich der Zahl der aufzunehmenden Prüflingsanschlüsse maximal dimensioniert sein muß, um auch die anschlußreichsten Prüflinge testen zu können, daß sie andererseits dann aber beim Testen von Prüflingen mit relativ geringer Zahl externer Anschlüsse unwirtschaftlich arbeitet. Letzterem Nachteil kann auch nicht dadurch begegnet werden, daß am Testplatz eine Vielzahl abgestuft dimensionierter Testköpfe zur Verfügung gehalten werden, da die Mehrzahl dieser kostspieligen Systemkomponenten dauernd brachliegen würde.

Aus der DE-A-31 43 768 ist ein Adapter zum Anschließen der Kontaktpunkte eines Prüflings, insbesondere einer Leiterplatte, an eine Prüfeinrichtung bekannt. Der Adapter besteht aus einer Zwischenkontaktplatte, einer Rangierplatte und einer weiteren Kontaktplatte. Dabei verbinden die Kontaktstifte der Zwischenkontaktplatte die Prüflingskontakte zunächst mit der Rangierplatte. Auf der Rangierplatte erfolgt insbesondere mittels Drahtverbindungen eine derartige räumliche Umverteilung in der Kontaktanordnung, daß die Rangierplatte schließlich mit den Kontaktmitteln der weiteren Kontaktplatte in Verbindung gebracht werden kann. Von hier wird schließlich der Anschluß der Kontakte an die Prüfeinrichtung hergestellt.

Der Erfindung liegt daher die Aufgabe zugrunde, eine Einrichtung der eingangs genannten Art so flexibel und wirtschaftlich zu gestalten, daß Prüflinge unterschiedlichster Anschlußzahl unter größtmöglicher Auslastung der vorhandenen Prüfkapazität, nämlich der Zahl der von den Testköpfen aufnehmbaren Prüflingsanschlüsse, prüfbar sind.

Diese Aufgabe wird durch die kennzeichnenden Merkmale des Anspruchs 1 gelöst. Vorteilhafte weitere Ausgestaltungen dieser Lösung sind Gegenstand der weiteren Ansprüche.

Der Vorteil der erfindungsgemäßen Lösungen besteht in der Flexibilität der Prüfeinrichtung hinsichtlich der Prüfung von Prüflingen unterschiedlichster Anschlußzahl und der damit einhergehenden wirtschaftlichen Nutzbarkeit der Prüfkapazität der Testköpfe. Dabei weist die Lösung nach Anspruch 1 — bei vorgegebener Prüfkapazität — als immanenten Vorteil noch die Option auf, bei Bedarf mehrere räumlich getrennte Testplätze einzurichten.

Die Ausgestaltung der Testköpfe nach Anspruch 2, nämlich die außermittige Anordnung ihrer Anschlußfelder, hat den Vorteil, daß diese bei nebeneinander stehenden Testköpfen so nahe wie möglich beieinander liegen, wodurch der zugehörige Sonderadapter kleinere Abmessungen aufweist und der Anschlußweg zwischen Prüfling und Testköpfen minimal wird, was für hohe Prüftaktfrequenzen eine notwendige Forderung darstellt.

Die Merkmale des Anspruches 3 ergeben eine vorteilhafte An- und Abschließbarkeit zwischen Prüfling(en) und Sonderadapter einerseits und zwischen Sonderadapter und Testköpfen (Testkopf) andererseits.

Der Vorteil der Kühlluftstromlenkung nach Anspruch 4 liegt in der Vermeidung von Wärmekurzschlüssen nebeneinander aufgesteller Testköpfe.

Der Anspruch 5 beinhaltet eine besonders vorteilhafte Prüfablauforganisation.

Anhand der in den Zeichnungen dargestellten Ausführungsbeispiele wird die Erfindung näher erläutert. Es zeigen :

Fig. 1 in schematischer Form eine Testeinrichtung mit zwei an einen Hauptrechner gekoppelten Testköpfen,

Fig. 2 einen Testkopf in Einzelbetrieb,

Fig. 3 zwei Testköpfe in Tandem-Konfiguration zur Prüfung eines anschlußreichen Prüflings,

Fig. 4 ein Schnittbild der Anordnung aus Fig. 3.

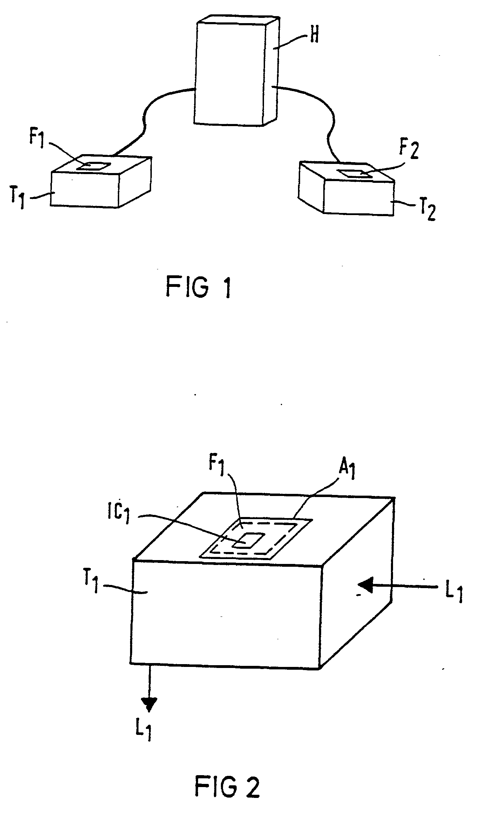

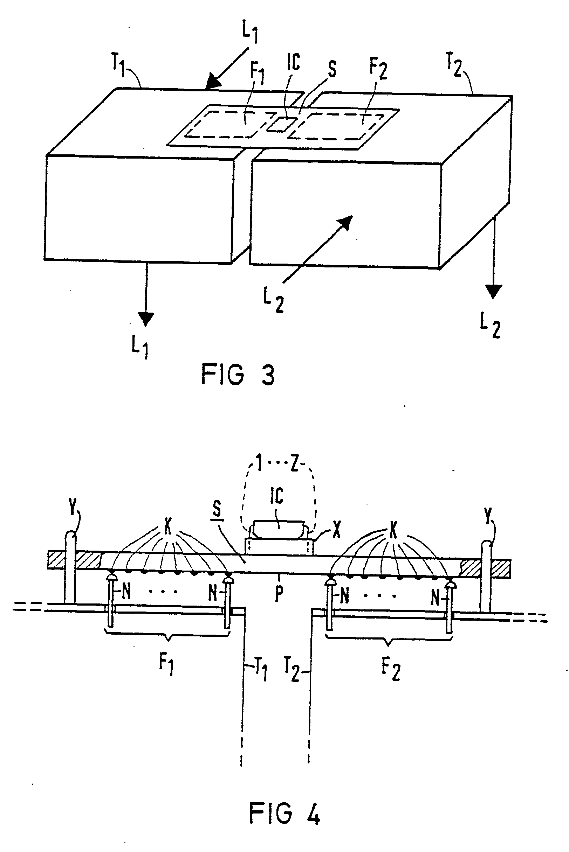

Die Testeinrichtung nach Fig. 1 besteht aus einem Hauptrechner H und den Testköpfen $T_1$, $T_2$. Der Hauptrechner H speichert Prüfprogramme, delegiert sie an die Testköpfe, überwacht die Prüfabläufe, erstellt Prüfprotokolle und -statistiken, steuert etwaige Beschickungseinrichtungen usw. Die Testköpfe $T_1$, $T_2$ sind hier baugleich angenommen, was sich aus wirtschaftlichen Gründen empfiehlt, und besitzen die Gestalt gemäß Fig. 2. Auf der Oberseite des beispielhaft gezeigten Testkopfes $T_1$ ist dessen dezentrales Anschlußfeld $F_1$ angedeutet, das z. B. in einem 8mal 8-Raster angeordnete federnde Kontaktnadeln N (in einem Schnitt dargestellt in Fig. 4) bilden. Die Kontaktnadeln N stellen die elektrische Verbindung zum Adapter $A_1$ her, der in einer Steckfassung den Prüfling $IC_1$ trägt. Im Inneren des Testkopfes $T_1$ befindet sich die periphere Hardware zur Ansteuerung der Prüflingsanschlüsse (Pin-Elektronik), da für schnelle Prüfvorgänge, d. h. für hohe Prüftaktfrequenzen, möglichst kurze Signalwege zwischen Ansteuerelektronik und Prüflingsanschlüssen notwendig sind. Gleichzeitig sollen die Signalwege zu den einzelnen Prüflingsanschlüssen möglichst gleich lang sein, damit es beim Anlegen der Prüfsignale nicht zu Laufzeitunterschieden (skew) mit der Folge irregulärer Testergebnisse kommt.

Die Pin-Elektronik weist in schnellen Testeinrichtungen einen erheblichen Umfang auf, z. B. pro Prüflingsanschluß einen Datenprozessor zuzüglich Daten- und Programmspeichern. Daraus leitet sich aus Wirtschaftlichkeitsgründen die Forderung nach maximaler Nutzung der Prüfkapazität, d. h. der von einem Testkopf aufnehmbaren Prüflingsanschlüsse, ab. Zugleich besteht aber das Bedürfnis, in einer vorhandenen Testeinrichtung Prüflinge mit unterschiedlichster Zahl von Anschlüssen prüfen zu können. Diese gegensätzlichen Forderungen werden von einer flexiblen Testeinrichtung erfüllt, deren zwei Testköpfe $T_1$, $T_2$ jeweils eine mittlere Prüfkapazität aufweisen (nach heutigen Maßstäben z. B. 64 Prüflingsanschlüsse aufnehmen können) und bei Bedarf zur Prüfung eines anschlußreicheren Prüflings IC (mit bis zu 128 externen Anschlüssen im genannten Beispiel) zusammenarbeiten (siehe Fig. 3, 4). Für diesen Zweck ist die aussermittige Anordnung der Anschlußfelder $F_1$, $F_2$ (siehe Fig. 2, 3, 4) von großem Vorteil, weil die Testköpfe $T_1$, $T_2$ dadurch mit einander zugewandten Anschlußfeldern $F_1$, $F_2$ nebeneinander aufstellbar sind, wodurch sich kurze Anschlußwege zum Prüfling IC ergeben. Dieser wird in der Steckfassung X des Sonderadapters S plaziert, dessen Platte P beide Anschlußfelder $F_1$, $F_2$ der nebeneinander stehenden Testköpfe $T_1$, $T_2$ überdeckt, über Zentrierstifte Y an den Testköpfen $T_1$, $T_2$ fixiert ist und über im Raster der Anschlußfelder $F_1$, $F_2$ angeordnete Anschlußkontakte K mit den federnden Kontaktnadeln N der Pin-Elektronik beider Testköpfe $T_1$, $T_2$ elektrisch verbunden ist.

Der Hauptrechner H gibt den Testköpfen $T_1$, $T_2$ die Prüfprogrammteile vor, die zusammen das Prüfprogramm für den anschlußreichen Prüfling IC realisieren. Ein Testkopf $T_1$ übernimmt die Führung des Prüfablaufs und synchronisiert den Testkopf $T_2$.

Die umfangreiche Elektronik in den Testköpfen $T_1$, $T_2$ bedarf u.U. der Zufuhr von Kühlluft durch Gebläse. Damit bei der Tandem-Aufstellung der Testköpfe $T_1$, $T_2$ gemäß Fig. 3 ein Wärmekurzschluß ausgeschlossen ist, ist der in Fig. 2 wiedergegebene Weg des Kühlluftstroms $L_1$ für den Testkopf $T_1$ vorgesehen; der Testkopf $T_2$ wird analog belüftet. Durch eine derjenigen Seitenflächen jedes Testkopfgehäuses, die dem beigeordneten anderen Testkopf $T_2$, $T_1$ abgewandt sind, werden die Kühlluftströme $L_1$ bzw. $L_2$ in die Testköpfe $T_1$, $T_2$ hinein- und jeweils durch die Bodenfläche der Testkopfgehäuse wieder herausgeführt. Die Orientierung der Kühlluftströme $L_1$, $L_2$ ist dabei von untergeordneter Bedeutung, sie muß nur für beide Testköpfe $T_1$, $T_2$ die gleiche sein, da sonst ein Testkopf die Abluft des anderen Testkopfes ansaugt. Jedenfalls lassen sich auf diese Weise zweckmäßig Testköpfe $T_1$, $T_2$ einsetzen, die auch hinsichtlich ihres Kühlsystems baugleich sind.

## Patentansprüche

1. Einrichtung für die Funktionsprüfung von elektronischen Prüflingen mit einer Vielzahl von Prüflingsanschlüssen, insbesondere von integrierten Schaltkreisen, mit

a) Testköpfen, welche über je ein Anschlußfeld mit ansteuerbaren Kontakten für die Prüflingsanschlüsse verfügen, an die der Prüfling über Adapter anschließbar ist,

b) einem Hauptrechner, welcher die Testköpfe mittels eines Prüfprogramms derart ansteuert, daß über die ansteuerbaren Kontakte eines Anschlußfeldes an die Prüflingsanschlüsse elektrische Signale angelegt und/oder von dort abgefragt werden,
gekennzeichnet durch

c) einen Sonderadapter (S) für einen Prüfling (IC), dessen Anzahl an Prüflingsanschlüssen größer ist als die Anzahl der ansteuerbaren Kontakte auf dem Anschlußfeld eines der Testköpfe, mit dem ein Teil der Prüflingsanschlüsse an die ansteuerbaren Kontakte des Anschlußfeldes ($F_1$) eines ersten Testkopfes ($T_1$) und der restliche Teil an die ansteuerbaren Kontakte des Anschlußfeldes ($F_2$) von mindestens einem weiteren, in räumlicher Nähe befindlichen Testkopf ($T_2$) anschließbar ist, wobei die Steuerung der mindestens zwei Testköpfe in einem gemeinsamen Prüfprogramm des Hauptrechners koordiniert wird.

2. Prüfeinrichtung nach Anspruch 1, dadurch gekenzeichnet, daß auf einer Außenseite des Gehäuses von mindestens einem Testkopf ($T_1$, $T_2$) das Anschlußfeld ($F_1$, $F_2$) außerhalb der Mitte, insbesondere am Rand, angeordnet ist.

3. Prüfeinrichtung nach Anspruch 1 oder 2, gekennzeichnet durch einen in Form einer Platte (P) ausgebildeten Sonderadapter (S) mit

a) einer Steckfassung (X) zur Aufnahme des Prüflings (IC) auf der Oberseite, und

b) auf der Unterseite in Gruppen angeordnete Anschlußkontakte (K), wobei die Anschlußkontakte innerhalb der Gruppen entsprechend dem Rastermaß der ansteuerbaren Kontakte (N) im Anschlußfeld eines der Testköpfe angeordnet sind.

4. Prüfeinrichtung nach einem der vorangegangenen Ansprüche, dadurch gekennzeichnet, daß eine Öffnung für den Kühlluftstrom ($L_1$ bzw. $L_2$) jedes Testkopfes ($T_1$, $T_2$) sich in einer derjenigen Seitenflächen jedes Testkopfgehäuses befindet, die dem mindestens einen in räumlicher Nähe befindlichen anderen Testkopf ($T_1$, $T_2$) abgewandt sind, eine weitere Öffnung für den Kühlluftstrom ($L_1$ bzw. $L_2$) jedes Testkopfes ($T_1$, $T_2$) in der Bodenfläche jedes Testkopfgehäuses liegt und die Orientierung der Kühlluftströme ($L_1$ bzw. $L_2$) aller Testköpfe ($T_1$, $T_2$) übereinstimmt.

5. Prüfeinrichtung nach einem der vorangegangenen Ansprüche, dadurch gekennzeichnet, daß einer der mit dem Sonderadapter (S) verbundenen Testköpfe ($T_1$) den Ablauf des vom Hauptrechner (H) vorgegebenen Prüfprogrammes für alle mit dem Sonderadapter (S) verbundenen Testköpfe ($T_1$, $T_2$) synchronisiert.

**Claims**

1. Arrangement for checking the functioning of electronic test pieces with multiple test piece connections, particularly integrated circuits, with

a) test heads, each of which has a connection area with controllable contacts for the test piece connections, to which the test piece can be connected by means of an adapter,

b) a main computer, which controls the test heads by means of a test program so that electrical signals are applied to and/or scanned from the test piece connections by the controllable contacts of the connection area, characterised by

c) a special adapter (S) for a test piece (IC), the number of test piece connections of which is greater than the number of the controllable contacts on the connection area of one of the test heads, by means of which some of the test piece connections can be connected to the controllable contacts of the connection area ($F_1$) of a first test head ($T_1$) and the remainder to the controllable contacts of the connection area ($F_2$) of at least one other adjacent test head ($T_2$), the control of the minimum of two test heads being coordinated in a common test program of the main computer.

2. Test arrangement as in Claim 1, characterised in that the connection area ($F_1$, $F_2$) is positioned eccentrically, particularly on the edge, on one outer surface of the casing of at least one test head ($T_1$, $T_2$).

3. Test arrangement as in Claim 1 or 2, characterised by a special adapter (S), having the form of a plate (P), with

a) on the upper face, a plug-in socket (X) for receiving the test piece (IC), and

b) on the lower face, connecting contacts (K) arranged in groups, the connecting contacts being arranged within the groups to correspond to the spacing of the controllable contacts (N) in the connection area of one of the test heads.

4. Test arrangement as in any one of the preceding Claims, characterised in that there is an opening for the cooling air flow ($L_1$ or $L_2$) for each test head ($T_1$, $T_2$) in one of the sides of each test head casing which face away from the at least one adjacent other test head ($T_1$, $T_2$), in that another opening for the flow of cooling air ($L_1$ or $L_2$) for each test head ($T_1$, $T_2$) is located in the base of each test head casing, and in that the cooling air flows ($L_1$ or $L_2$) for all test heads ($T_1$, $T_2$) have the same orientation.

5. Test arrangement as in any one of the preceding Claims, characterised in that one of the test heads ($T_1$) connected to the special adapter (S) synchronises the execution of the test program preset by the main computer (H) for all test heads ($T_1$, $T_2$) connected to the special adapter (S).

**Revendications**

1. Dispositif pour tester le fonctionnement de spécimens électroniques comportant une multiplicité de bornes, notamment des circuits intégrés, comportant

a) des têtes d'essai, qui disposent d'une zone de raccordement comportant des contacts, pouvant être commandés, qui sont prévus pour les bornes du spécimen et auxquelles ce dernier peut être raccordé par l'intermédiaire d'un adaptateur,

b) un ordinateur principal qui commande les têtes d'essai à l'aide d'un programme d'essai de telle sorte que des signaux électriques sont appliqués, par l'intermédiaire des contacts pouvant être commandés d'une zone de raccordement, aux bornes du spécimen et/ou peuvent être appelés à partir de ces bornes, caractérisé par

c) un adaptateur particulier (S) prévu pour un spécimen (IC), dont le nombre de bornes est supérieur au nombre des contacts, pouvant être commandés, présents dans la zone de raccordement de l'une des têtes d'essai, à laquelle une partie des bornes du spécimen peuvent être raccordées au niveau des contacts, pouvant être commandés, de la zone de raccordement ($F_1$) d'une première tête d'essai ($T_1$), tandis que le reste des bornes du spécimen peut être raccordé aux contacts, pouvant être commandés, de la zone de raccordement ($F_2$) d'au moins une autre tête d'essai ($T_2$), située à proximité dans l'espace, la commande des têtes d'essai, prévues au moins au nombre de deux, étant coordonnée dans un programme d'essai commun de l'ordinateur principal.

2. Dispositif d'essai suivant la revendication 1, caractérisé par le fait que la zone de raccordement ($F_1$, $F_2$) est située en position décentrée et notamment au niveau du bord, sur une face extérieure du boîtier d'au moins une tête d'essai $(T_1, T_2)$.

3. Dispositif d'essai suivant la revendication 1 ou 2, caractérisé par un adaptateur particulier (S) réalisé sous la forme d'une plaque (P) et comportant

    a) une monture d'enfichage (X) destinée à recevoir le spécimen (IC), situé sur la face supérieure, et

    b) des contacts de raccordement (K) disposés en étant répartis par groupes sur la face inférieure, les contacts de raccordement des groupes étant disposés conformément au pas du réseau des contacts (N), qui peuvent être commandés, dans la zone de raccordement de l'une des têtes d'essai.

4. Dispositif d'essai suivant l'une des revendications précédentes, caractérisé par le fait qu'une ouverture pour le courant d'air de refroidissement ($L_1$ ou $L_2$) de chaque tête d'essai ($T_1, T_2$) est située dans l'une des surfaces latérales de chaque boîtier d'une tête d'essai, qui sont tournées à l'opposé d'au moins une autre tête d'essai ($T_1$, $T_2$) située à proximité dans l'espace, qu'une autre ouverture pour le courant d'air de refroidissement ($L_1, L_2$) de chaque tête d'essai ($T_1, T_2$) est située dans la surface du fond de chaque boîtier de la tête d'essai et que l'orientation des courants d'air de refroidissement ($L_1$ ou $L_2$) de toutes les têtes d'essai ($T_1, T_2$) est la même.

5. Dispositif d'essai suivant l'une des revendications précédentes, caractérisé par le fait que l'une des têtes d'essai ($T_1$) reliées à l'adaptateur particulier (S) synchronise le déroulement du programme d'essai déterminé par l'ordinateur principal (H), pour toutes les têtes d'essai ($T_1, T_2$) reliées à l'adaptateur particulier (S).

FIG 1

FIG 2

1

FIG 3

FIG 4